(19) Europäisches Patentamt
European Patent Office
Office européen des brevets

(11) **EP 4 455 792 A2**

(12) **EUROPEAN PATENT APPLICATION**

(43) Date of publication:
**30.10.2024 Bulletin 2024/44**

(21) Application number: **24192959.5**

(22) Date of filing: **05.03.2021**

(51) International Patent Classification (IPC):
**G03F 7/20** *(2006.01)*

(52) Cooperative Patent Classification (CPC):
(C-Sets available)
**B33Y 70/00; B29C 64/124; B33Y 10/00;
C08F 220/58; C08F 222/1006; C08F 222/1065;
C09D 11/101; C09D 11/104; C09D 11/38;
G03F 7/0037; G03F 7/027; G03F 7/029;
G03F 7/031; G03F 7/2012;** C08F 2/50 (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.03.2020 PCT/CN2020/079285**

(62) Document number(s) of the earlier application(s) in
accordance with Art. 76 EPC:
**21711489.1 / 4 117 918**

(71) Applicant: **BASF SE
67056 Ludwigshafen am Rhein (DE)**

(72) Inventor: **The designation of the inventor has not
yet been filed**

(74) Representative: **Ellwanger, Arndt
Ellwanger & Baier
Patentanwälte Partnerschaftsgesellschaft
Friedrichsplatz 9
68165 Mannheim (DE)**

Remarks:
This application was filed on 05-08-2024 as a
divisional application to the application mentioned
under INID code 62.

(54) **PHOTO-CURABLE COMPOSITION FOR 3D PRINTING, ITS PREPARATION AND USE, AND
METHOD OF FORMING 3D-PRINTED OBJECTS BY USING THE SAME**

(57)    The invention relates to a photo-curable liquid resin composition for 3D printing and its preparation process.

**(Cont. next page)**

EP 4 455 792 A2

(52) Cooperative Patent Classification (CPC): (Cont.)

C-Sets
C08F 220/58, C08F 222/1065, C08F 220/1811;
C08F 222/1065, C08F 220/20, C08F 220/58

**Description**

**TECHNICAL FIELD**

The present invention belongs to the technical field of chemical materials for three-dimensional (hereinafter referred to as "3D") printing, and in particular relates to a photo-curable composition for 3D printing, its preparation process and use, and also to a method of forming a 3D-printed object by using the composition.

**BACKGROUND**

In recent years, 3D printing technologies have been used to produce a large number of items in a short period of time. For example, CN 106186810A has disclosed a 3D printing building materials and CN 105419306A has disclosed a 3D printed floor. There are several ways to build three-dimensional articles using photo-curable materials including Stereolithography (SLA), Digital light process (DLP) and photopolymer jetting (PJ). In a 3D printer using the DLP or SLA technology, the photo-curable material, which is in a liquid form, is layered on a vat or spread on a sheet, and a predetermined area or surface of the photo-curable material is exposed to ultraviolet-visible (UV/Vis) light that is controlled by a digital micro-mirror device or rotating mirror. In the DLP technology, additional layers are repeatedly or continuously laid, and each layer is cured until a desired 3D article is formed. The SLA technology is different from the DLP technology in that the liquid material is solidified by a line of radiation beam. Photopolymer jetting technology utilizes inkjet print heads to jet a liquid photopolymer which is immediately cured by a UV lamp and solidified to build layers on top of each other.

3D-printing using photo-curable material has been adopted in many applications, e.g. rapid pro-totyping, manufacturing of hearing aids and other on-demand manufacturing. For example, WO 2014/172716A1 has disclosed the manufacturing of denture base and artificial teeth by using photo-curable liquid compositions and 3D-printing technology.

Conventional commercially available photo-curable materials for 3D printing are predominantly based on substances which are too hard in the cured state and possess rigid and brittle material properties, and such materials are suitable only for particular fields of application. One challenge encountered with 3D printing articles using photo-curable materials is low elasticity and low flexibility if flexible and elastic shaped objects are needed as models or other construction elements. For the purpose of obtaining 3D printed objects with good elasticity and flexibility, urethane (meth)acrylate oligomer is conventionally used as oligomeric photo-curable material. Some attempts have been made recently. For example, WO 201615371 1A1 discloses a 3D-printing photo-curable composition comprising a photo-curable urethane acrylate/epoxy-based composition for a flexible material-based object. However, it still remains a challenge to provide an appropriate photo-curable composition for making a flexible and elastic 3D printed object.

Another challenge encountered with 3D printing process is to maintain a suitable viscosity of photo-curable materials. A high viscosity photo-curable material is not desirable in three dimensional processes, in particular stereolithography. The photo-curable liquid resin formulation comprising urethane acrylate oligomer has high viscosity and thus additionally comprises a diluent for lowering viscosity and in most preferred case, the diluent in the applied liquid is a reactive diluent, such as monomer components. However, it is possible that incorporating of reactive diluents would sacrifice elasticity and flexibility of the final printed objects. Therefore, there is a strong need to develop a photo-curable composition to be used in 3D printing which has desirable flexible and elastic material properties in the cured state.

**SUMMARY OF THE PRESENT INVENTION**

An object of this invention is to provide a photo-curable composition for 3D printing, which has satisfactory flexible and elastic in the cured state, while having a suitable viscosity for 3D printing process.

Surprisingly, the above object has been achieved by a photo-curable liquid resin composition for 3D printing, comprising

(A) 1 to 90% by weight of an oligomer containing an ethylenically unsaturated radiation curable functional group;
(B) 1 to 90% by weight of a plasticizer;
(C) 0 to 90% by weight of reactive diluent;
(D) 0.1 to 10% by weight of a photoinitiator; and
(E) 0 to 5% by weight of auxiliaries,

wherein the total weight of components (A) to (E) is 100% by weight.

According to an aspect of the invention, the oligomer containing an ethylenically unsaturated radiation curable functional group (A) includes an oligomer containing an ethylenically unsaturated radiation curable mono- and/or poly-functional group.

In a further aspect, the invention relates to a process for preparing the above photo-curable liquid resin composition, comprising mixing the components (A) to (E) in the amounts as defined above.

In another aspect, the invention relates to the use of the above photo-curable liquid resin composition for forming 3D-printed objects.

In a still further aspect, the invention relates to a method of forming 3D-printed objects, comprising using the above photo-curable liquid resin composition as the raw material for 3D printing.

It has been surprisingly found that the article obtained by printing the composition according to the present invention has superior elasticity, achieves the reduction of tensile modulus and hardness, and exhibits lower Tg, which provides widely temperature range for practical use. Thus, the composition is suitable for producing 3D-printed objects with higher elasticity and flexibility requirements.

## BRIEF DESCRIPTION OF THE DRAWING

The present invention will be described with reference to the figures, which are not intended to limit the present invention.

FIG. 1 shows a stereogram of an exemplary 3D-printed objects obtained by printing the composition in example 5b.

FIG. 2 shows a schematic diagram illustrating Area Under Unloading Curve and Area Under Loading Curve in Cyclic Tensile Test used in the examples.

## DETAILED DESCRIPTION OF THE PRESENT INVENTION

Unless defined otherwise, all technical and scientific terms used herein have the meaning commonly understood by a person skilled in the art to which the invention belongs. As used herein, the following terms have the meanings ascribed to them below, unless specified otherwise.

As used herein, the articles "a" and "an" refer to one or more than one (i.e., at least one) of the grammatical object of the article. By way of example, "an element" means one element or more than one element.

As used herein, the term "about" is understood to refer to a range of numbers that a person of skill in the art would consider equivalent to the recited value in the context of achieving the same function or result.

As used herein, the term "auxiliaries" refers to additives included in a formulated system to enhance physical or chemical properties thereof and to provide a desired result. Such additives include, but are not limited to, dyes, pigments, toughening agents, impact modifiers, rheology modifiers, thixotropic agents, natural or synthetic rubbers, filler agents, reinforcing agents, thickening agents, inhibitors, fluorescence or other markers, thermal degradation reducers, thermal resistance conferring agents, surfactants, wetting agents, defoaming agents, dispersants, flow or slip aids, biocides, and stabilizers.

In the context of the present application, numerical range used is understood means all number between upper and lower limits, including integer and uneven number; for example, numerical range"1 to 90" is understood means all number between 1 and 90, including integer 1, 2, 3, 4, 5... 88, 89, 90 and uneven 1.1, 1.8, 2.5, 3.7... 88.6, 89.5....

As used herein, the term "comprising", is synonymous with "including" containing" or "characterized by", is inclusive or open-ended and does not exclude additional, unrecited elements, material, or steps.

As used herein, the term "(meth)acrylate" refers to a functional group, moiety or substituent which may be an acrylate and/or a methacrylate.

As used herein, the term "monofunctional group" refers to a group whose functionality is 1, and the term" polyfunctional group" refers to a group whose functionality is more than 1.

As used herein, the term "photo curable" means initiation of cure of the composition may be accomplished by exposure to actinic light or radiation.

The terms definitions or elucidations given above in general terms or within areas of preference apply to the end products and correspondingly to the starting materials and intermediates. These terms definitions can be combined with one another as desired, i.e. including combinations between the general definition and/or the respective ranges of preference and/or the embodiments.

Unless otherwise identified, all percentages (%) are "percent by weight".

Unless otherwise identified, the temperature refers to room temperature and the pressure refers to ambient pressure.

In one aspect, the invention provides a photo-curable liquid resin composition for 3D printing, comprising

(A) 1 to 90% by weight of an oligomer containing an ethylenically unsaturated radiation curable functional group;
(B) 1 to 90% by weight of a plasticizer;

(C) 0 to 90% by weight of reactive diluent;

(D) 0.1 to 10% by weight of a photoinitiator; and

(E) 0 to 5% by weight of auxiliaries,

wherein the total weight of components (A) to (E) is 100% by weight.

Component (A)

The oligomer containing an ethylenically unsaturated radiation curable functional group suitable for use in the present invention provides a template for a backbone. According to a preferred embodiment of the invention, oligomer (A) is an oligomer containing an ethylenically unsaturated radiation curable mono- and/or poly-functional group.

In an embodiment of the invention, the ethylenically unsaturated radiation curable functional group comprises at least one ethylenically unsaturated bond (vinyl function) such as those found in the following functional groups: allyl, vinyl, acrylate, methacrylate, acryloxy, methacryloxy, acrylamido, methacrylamido, acetylenyl, maleimido, and the like.

In a preferred embodiment of the invention, the ethylenically unsaturated radiation curable mono- and/or poly-functional group comprises, in addition to the above groups, urethane groups, ether groups, ester groups, carbonate groups, and any combination thereof. Suitable mono- and/or polyfunctional ethylenically unsaturated compounds include, for example, compounds containing a core structure linked to ethylenically unsaturated groups, optionally via a linking group. The linking group can be an ether, ester, amide, urethane, carbomate, or carbonate functional group. In some instances, the linking group is part of the ethylenically unsaturated group, for instance an acryloxy or acrylamido group. The core group can be an alkyl (straight and branched chain alkyl groups), aryl (e.g. phenyl), polyether, siloxane, urethane, or other core structures and oligomers thereof. Suitable ethylenically unsaturated mono- and/or polyfunctional groups may comprise methacrylate, acrylate, vinyl ether, allyl ether, acrylamide, methacrylamide, carbon-carbon double bond, or a combination thereof. In some embodiments, suitable oligomers comprising ethylenically unsaturated mono- and/or polyfunctional group comprise mono- and/or polyfunctional acrylate, such as monoacrylate, diacrylate, triacrylate, or higher, or combination thereof. Optionally, the oligomer including mono- and/or polyfunctional group may include a siloxane backbone in order to further improve cure, flexibility and or additional properties of the photo-curing composition for 3D printing.

In some embodiments, suitable oligomers for use in the photo-curing composition for 3D printing of the present invention include ethylenically unsaturated oligomers of the following general classes: urethane, polyether, polyester, polycarbonate, polyestercarbonate, acrylic, silicone and the like, as well as any combination or subset thereof. In some specific embodiments, suitable oligomers include a urethane-based oligomer, an acrylate-based oligomer, a urethane acrylate-based oligomer, a polyester-based oligomer, a polyether-based oligomer, a polyether urethane-based oligomer, a polyester urethane-based oligomer, a silicone-based oligomer or any combination or subset thereof.

In a preferred embodiment of the invention, oligomer (A) comprises a urethane oligomer comprising urethane repeating units and one, two or more ethylenically unsaturated functional groups such as (meth)acrylate, allyl, and/or vinyl groups. Preferably, the oligomer contains at least one urethane linkage (in some embodiments, two or more urethane linkages) within the backbone of the oligomer molecule and at least one acrylate and/or methacrylate functional groups (in some embodiments, two or more acrylate and/or methacrylate functional groups) pendent to the oligomer molecule. By using such an oligomer (A), obvious improvement in flexibility or elasticity and other mechanical properties provided by plasticizer can be achieved. In some embodiments, aliphatic, cycloaliphatic, or mixed aliphatic and cycloaliphatic urethane repeating units are suitable. Urethanes are typically prepared by the condensation of a diisocyanate with a diol. Aliphatic urethanes having at least two urethane moieties per repeating unit are useful, wherein the diisocyanate and diol used to prepare the urethane comprise divalent aliphatic groups that may be the same or different.

In some embodiments, oligomer (A) comprises polyester and polyether urethane oligomers functionalized with ethylenic unsaturation. The ethylenic unsaturation may be provided by functional group such as acrylate, $C_1$-$C_4$ alkyl(acrylate) (e.g. methacrylate, ethacrylate, etc), vinyl, allyl, acrylamide, $C_1$-$C_4$ alkyl(acrylamide), and the like. The reactive functionality of these urethane acrylates is 1 or greater, specifically about 2 reactive groups per oligomer molecule.

Suitable polyether or polyester ethylenically unsaturated urethane oligomers include the reaction product of an aliphatic or aromatic polyether or polyester polyol with an aliphatic or aromatic polyisocyanate that is functionalized with ethylenic unsaturation using a monomer containing the ethylenic unsaturation. Such oligomers may be prepared by using procedures well known in the art. The example of the polyester or polyether ethylenically unsaturated oligomers include Laromer® PE-56F from BASF SE, for example.

Suitable urethane (meth)acrylate oligomers are well-known in the art and may be readily synthesized by a number of different procedures. For example, a polyfunctional alcohol may be reacted with a polyisocyanate (preferably, a stoichiometric excess of polyisocyanate) to form an NCO-terminated pre-oligomer, which is thereafter reacted with a hydroxy-functional (meth)acrylate. The polyfunctional alcohol may be any compound containing two or more OH groups per molecule and may be a monomeric polyol (e.g., a glycol), a polyester polyol, a polyether polyol or the like. The urethane (meth)acrylate oligomer in one embodiment of the invention is an aliphatic urethane (meth)acrylate oligomer. Examples of suitable urethane (meth)acrylate oligomers are commercially available from Allnex under the trade name EBECRYL® 8413 and 8411, and from BASF SE under the trade name Laromer® UA9033 and from Dymax under the trade name Bomar® BRC-843S.

For the purpose of the invention, molecular weight of oligomer (A) is not critical and can be in any range suitable for use in 3D-printing, which can be selected by those skilled in the art according to practical requirements.

In one embodiment, oligomer (A) is present in an amount of from 5 to 80% by weight, based on the total weight of components (A) to (E). According to the invention, there is no specific restriction with respect to the amount of oligomer (A). Generally, the amount of oligomer (A) depends on the 3D printing machine with different requirement on viscosity etc.

Component (B)

Plasticizers work by being embedded between the chains of polymers, spacing them apart (increasing the "free volume"), and thus significantly lowering the glass transition temperature of the plastic and making it softer. It has been surprisingly found by the inventors that the plasticizers can stably exist in the 3D-printed network according to the present invention.

The type of the plasticizer used in the invention is in principle not particularly limited. Any plasticizers known for those skilled in the art are suitable to the invention. The example of plasticizers used in this invention are $C_3$-$C_{15}$-, preferably $C_3$-$C_{10}$-polycarboxylic acids and their esters with linear or branched $C_2$-$C_{30}$-aliphatic alcohols, benzoates, epoxidized vegetable oils, sulfonamides, organophosphates, glycols and its derivatives, polyethers, polymeric plasticizers and polybutene. In some preferred embodiments, the plasticizers suitable for the present invention include but are not limited to $C_3$-$C_{15}$, preferably $C_3$-$C_{10}$ aromatic dicarboxylic or tricarboxylic acids and their esters with linear or branched $C_2$-$C_{30}$ aliphatic alcohols, or $C_3$-$C_{15}$, preferably $C_3$-$C_{10}$ aliphatic dicarboxylic or tricarboxylic acids and their esters with linear or branched $C_2$-$C_{30}$ aliphatic alcohols, such as adipic acid and adipates, sebacic acid and sebacate, maleic acid and maleates, azelaic acid and azelates, aromatic polycarboxylic acids and esters such as phthalic acid and phthalate-based plasticizers, cyclic aliphatic polycarboxylic acids and their esters such as cyclohexane dicarboxylic acid.

Preferred plasticizers are sebacic acid, sebacates, adipic acid, adipates, glutaric acid, glutarates, phthalic acid, phthalates (for example with $C_8$ alcohols), azelaic acid, azelates, maleic acid, maleate, citric acid and its derivatives, see for example WO 2010/125009, incorporated herein by reference. The plasticizers may be used in combination or individually.

One specific class of preferred plasticizers is phthalate-based plasticizers, such as phthalate esters of $C_8$ alcohols, which are advantageous for resistance to water and oils. Some preferred phthalate plasticizers are bis(2-ethylhexyl) phthalate (DEHP), preferably used in construction materials and medical devices, diisononyl phthalate (DINP), preferably used in garden hoses, shoes, toys, and building materials, di-n-butyl phthalate (DNBP, DBP), butyl benzyl phthalate (BBZP), preferably used for food conveyor belts, artificial leather, and foams, diisodecyl phthalate (DIDP), preferably used for insulation of wires and cables, car undercoating, shoes, carpets, pool liners, di-n-octyl phthalate (DOP or DNOP), preferably used in flooring materials, carpets, notebook covers, and high explosives, diisooctyl phthalate (DIOP), diethyl phthalate (DEP), and diisobutyl phthalate (DIBP), di-n-hexyl phthalate, preferably used in flooring materials, tool handles, and automobile parts.

Another preferred class of plasticizers are selected from the group consisting of adipates, sebacates and maleates, such as bis(2-ethylhexyl)adipate (DEHA), dimethyl adipate (DMAD), monomethyl adipate (MMAD), dioctyl adipate (DOA), diisodecyl adipate (DINA), dibutyl sebacate (DBS), dibutyl maleate (DBM), and diisobutyl maleate (DIBM). Adipate-based plasticizers are preferred, preferably used for low-temperature application and high resistance to ultraviolet light.

Other preferred plasticizers are selected from the group consisting of benzoates; epoxidized vegetable oils; sulfonamides, such as N-ethyl toluene sulfonamide (o/p ETSA), ortho- and para-isomers, N-(2-hydroxypropyl) benzene sulfonamide (HP BSA), N-(n-butyl) benzene sulfonamide (BBSA-NBBS); organophosphates, such as tricresyl phosphate (TCP), tributyl phosphate (TBP); glycols/polyether and their derivatives, such as triethylene glycol dihexanoate (3G6, 3GH), tetraethylene glycol diheptanoate (4G7); polymeric plasticizer, such as epoxidized oils of high molecular weight and polyester plasticizers, polybutene and polyisobutylene.

Polyester plasticizers are generally prepared by esterification of polyhydric alcohols, as for example 1,2-ethanediol, 1,2-propanediol, 1,3-propanediol, 1,3-butanediol, 1,4-butanediol, 1,5-pentanediol, or 1,6-hexanediol, with a polycarboxylic acid, such as succinic acid, glutaric acid, adipic acid, pimelic acid, suberic acid, sebacic acid, or azelaic acid. Optionally, it is possible for terminal alcohol groups (in the case of synthesis with alcohol excess) to be capped with monocarboxylic acids, such as acetic acid, or for terminal acid groups (in the case of synthesis with acid excess) to be capped with monohydric alcohols, such as 2-ethylhexanol, isononanol, 2-pro-pylheptanol or isodecanol. Examples of suitable commercial available polyester plasticizers are those available from BASF SE, under the brand name Palamoll® 638 (polyester plasticizer based on adipic acid, 1,2-propanediol and n-octanol), Palamoll® 652 (polyester plasticizer based on adipic acid, 1,2-propanediol, neopentyl glycol and isononanol), Palamoll® 654 (polyester plasticizer based on adipic acid, 1,4-butanediol, neopentyl glycol and isononanol) or Palamoll® 656 (polyester plasticizer based on adipic acid, 1,4-butanediol, neopentyl glycol and isononanol).

Another group of preferred plasticizers are biodegradable plasticizers, preferably selected from acetylated monoglycerides, preferably for the use as food additives, alkyl citrates, also preferably used in food packaging, medical products, cosmetics and children toys, such as triethyl citrate (TEC), acetyl triethyl citrate (ATEC), tributyl citrate (TBC), acetyl tributyl citrate (ATBC), especially compatible with PVC and vinyl chloride copolymers, trioctyl citrate (TOC), preferably used for gums and controlled release medicines, acetyl trioctyl citrate (ATOC), preferably used for printing ink, trihexyl citrate (THC), preferably used for controlled release medicines, acetyl trihexyl citrate (ATHC), butyryl trihexyl citrate, also referred to as BTHC, trihexyl o-butyryl citrate, trimethyl citrate (TMC), and also alkyl sulphonic acid phenyl ester (ASE).

Further preferred groups of plasticizers are selected from the group consisting of cyclohexane dicarboxylic acid and its esters, preferably esters of 1,2-cyclohexane dicarboxylic acid, more preferably 1,2-cyclohexane dicarboxylic acid diisononyl ester (such as Hexamoll® DINCH from BASF SE).

In a preferred embodiment, the plasticizer is mixed with the oligomer containing an ethylenically unsaturated radiation curable functional group, so that it is included in the latter.

In a preferred embodiment of the invention, the plasticizer (B) is present in an amount of from 5 to 85% by weight, more preferably from 5 to 80% by weight, most preferably from 5 to 70% by weight, particularly from 5 to 60% by weight, in each case based on the total weight of components (A) to (E).

Component (C)

According to an embodiment of the invention, one or more reactive diluents are present in the photo-curable composition for 3D printing of the present invention to lower the viscosity of the composition. Reactive diluents include a wide variety of free-radically polymerizable monomers such as monofunctional or polyfunctional monomer, which can comprise reactive groups like hydroxy groups, ethylenically unsaturated groups, epoxy groups, amino groups, or a combination thereof. Examples of reactive diluents include monofunctional and polyfunctional compounds, such as monomers containing a vinyl, acryl, acrylate, acrylamide, hydroxyl group among others. A reactive diluent typically is a mono-, di- or trifunctional monomer or oligomer having a low molecular weight. Typical examples are acrylic acid, acrylate monomers, include but are not limited to, urethane acrylate, methyl(meth)acrylate, ethyl(meth)acrylate, butyl(methyl)acrylate, 2-(2-ethoxy)ethyl acrylate, tetrahydrofurfuryl (meth)acrylate, lauryl acrylate, isooctyl acrylate, isodecyl acrylate, 2-phenoxyethylacrylate, 2-ethylhexyl (meth)acrylate, isobornyl (meth)acrylate, dicyclopentenyloxyethyl (meth)acrylate, dicyclopentadienyl (meth)acrylate, 2-hydroxyethyl (meth)acrylate, 2-hydroxypropyl (meth)acrylate, 2-hydroxybutyl (meth)acrylate, 4-hydroxybutyl (meth)acrylate, caprolactone acrylate, morpholine (meth)acrylate, hexanediol di(meth)acrylate, ethyleneglycol dimethacrylate, trimethylolpropane triacrylate, pentaerythritol tetraacrylate, n-hexyl (meth)acrylate, stearyl acrylate, allyl acrylate, ethoxylated nonyl phenol acrylate, acrylated monomers and combinations thereof, and also vinyl alkyl oxazolidinone such as vinyl methyl oxazolidinone and acryloyl morpholine, preferably acrylate monomers such as urethane acrylate, isodecyl acrylate, 4-hydroxybutyl (meth)acrylate, trimethylolpropane acrylate, and acryloylmorpholine.

The above reactive diluent is commercially available or obtainable by the method known *per se* in the art.

In a preferred embodiment of the invention, the reactive diluent (C), if any, is present in an amount of from 0 to 80% by weight based on the total weight of components (A) to (E). According to the invention, there is no specific restriction with respect to the amount of the reactive diluent (C). Generally, the amount of the reactive diluent (C) depends on the 3D printing machine with different requirement on viscosity etc.

Component (D)

According to an embodiment of the invention, the photoinitiator component may include one or more common photoinitiators. For example, the photoinitiator component may include one or more free radical photoinitiators and/or one or more ionic photoinitiators, and preferably one or more free radical photoinitiators. For example, it is possible to use all photoinitiators known in the art for use in compositions for 3D-printing, e.g., it is possible to use photoinitiators that are known in the art use with SLA, DLP or PPJ (Photo polymer jetting) processes.

Exemplary photoinitiators may be a single compound, a mixture of two or more active compounds, or a combination of two or more different compounds (such as co-initiators). According to specifically aspects of the invention, the photoinitiators is selected from the group consisting of 1-hydroxycyclohexyl phenylketone, 2-methyl-1-[4-(methylthio)phenyl]-2-morpholinopropan-1-one, 2-benzyl-2-N,N-dimethylamino-1-(4-morpholinophenyl)-1-butanone, combination of 1-hydroxycyclohexyl phenyl ketone and benzophenone, 2,2-dimethoxy-2-phenyl acetophenone, bis(2,6-dimethoxybenzoy 1-2,4,4-trimethylpentyl)phosphine oxide, 2-hydroxy-2-methyl-1-phenyl-propan-1-one, bis(2,4,6-trimethyl benzoyl) phenyl phosphine oxide, 2-hydroxy-2-methyl-1-phenyl-1-propane, combination of 2,4,6-trimethylbenzoyldiphenyl-phosphine oxide, 2-hydroxy-2-methyl-1-phenyl-propan-1-one, 2,4,6-trimethylbenzoyldiphenylphosphinate and 2,4,6-trimethylbenzoyldiphenyl-phosphine oxide and also any combination thereof.

In a preferred embodiment of the invention, photoinitiator (D) is present in an amount of from 0.1 to 5% by weight, more preferably from 0.1 to 4% by weight, in each case based on the total weight of components (A) to (E).

Component (E)

According to an embodiment of the invention, the composition may further comprise one or more auxiliaries.

As auxiliaries (E), mention may be made by way of preferred example of surface-active substances, flame retardants, nucleating agents, lubricant wax, dyes, pigments, catalyst, UV absorbers and stabilizers, e.g. against oxidation, hydrolysis, light, heat or discoloration, inorganic and/or organic fillers and reinforcing materials. As hydrolysis inhibitors, preference is given to oligomeric and/or polymeric aliphatic or aromatic carbodiimides. To stabilize the material cured of the invention against aging and damaging environmental influences, stabilizers are added to systemin preferred embodiments.

If the composition of the invention is exposed to thermo-oxidative damage during use, in preferred embodiments antioxidants are added. Preference is given to phenolic antioxidants. Phenolic antioxidants such as Irganox® 1010 from BASF SE are given in Plastics Additive Handbook, 5th edition, H. Zweifel, ed., Hanser Publishers, Munich, 2001, pages 98-107, page 116 and page 121.

If the composition of the invention is exposed to UV light, it is preferably additionally stabilized with a UV absorber. UV absorbers are generally known as molecules which absorb high-energy UV light and dissipate energy. Customary UV absorbers which are employed in industry belong, for example, to the group of cinnamic esters, diphenylcyan acrylates, formamidines, benzylidenemalonates, diarylbutadienes, triazines and benzotriazoles. Examples of commercial UV absorbers may be found in Plastics Additive Handbook, 5th edition, H. Zweifel, ed, Hanser Publishers, Munich, 2001, pages 116-122.

Further details regarding the abovementioned auxiliaries may be found in the specialist literature, e.g. in Plastics Additive Handbook, 5th edition, H. Zweifel, ed, Hanser Publishers, Munich, 2001.

In a preferred embodiment of the invention, auxiliaries (E) are if any, present in an amount of from 0 to 5% by weight, in each case based on the total weight of components (A) to (E).

The definitions and description concerning the composition also apply to the process and use of the present invention.

In a further aspect, the invention relates to a process for preparing said photo-curable liquid resin composition for 3D printing, comprising mixing the above components (A), (B), (C), (D) and optionally (E) in the amounts as defined above, with stirring.

According to an embodiment of the invention, the mixing is carried out at room temperature with stirring. There is no particular restriction on the time of mixing and rate of stirring, as long as the compositions (A) to (E) are uniformly mixed together. In a specific embodiment, the mixing is performed by means of a mixer at 1000 to 3000 RPM, preferably 1500 to 2500 RPM for 5 to 25 min, more preferably 8 to 20 min.

In another aspect, the invention relates to the use of the photo-curable liquid resin composition for forming 3D-printed objects.

According to an embodiment of the invention, the example of 3D-printed objects includes sole, outerwear, cloth, footwear, toy, mat, tire, hose, gloves, seals.

In a still further aspect, the invention relates to a method of forming 3D-printed objects, comprising using the above photo-curable liquid resin composition as the raw material for 3D printing.

The method of forming 3D-printed objects includes stereolithography (SLA), digital light processing (DLP) or photopolymer jetting (PPJ) and other technique known by the skilled in the art. Preferably, the production of cured 3D objects of complex shape is performed for instance by means of stereolithography, which has been known for a number of years. In this technique, the desired shaped article is built up from a photo-curable composition with the aid of a recurring, alternating sequence of two steps (i) and (ii). In step (i), a layer of the photo-curable composition, one boundary of which is the surface of the composition, is cured with the aid of appropriate imaging radiation, preferably imaging radiation from a computer-controlled scanning laser beam, within a surface region which corresponds to the desired cross-sectional area of the shaped article to be formed, and in step (ii) the cured layer is covered with a new layer of the photo-curable composition, and the sequence of steps (i) and (ii) is often repeated until the desired shape is finished.

In some embodiments, the method of forming a 3D object is performed by means of stereolithography, which comprises the steps of: (a) forming a layer of one of the photo-curable resin compositions described in the above embodiments; (b) applying actinic radiation to cure at least a portion of the layer of the photo-curable resin composition to form a cured layer; (c) introducing a new layer of the photo-curable resin composition onto the cured layer; (d) applying actinic radiation to the new layer of the photo-curable resin composition to form a cured layer; (e) repeating steps (c) and (d) until the 3D object is manufactured.

In an embodiment of the invention, the method may further comprise a step of post-curing the 3D object obtained in step (e) as a whole to form a final 3D object. Preferably, in this step, UV radiation is used to post-cure the 3D object obtained in step (e) as a whole to form a final 3D object. It should be understood that in this step, thermal treatment (for example, <80◦C) can be also considered as a kind of post-curing process.

According to the invention, the curing time in step (b) or (d) is from 1 to 10 s, preferably from 2 to 6 s. According to the invention, the post-curing time is from 0 min to 120 min, preferably from10 min to 90 min.

There is no specific restriction on temperature during curing. Specifically, the temperature during curing depends on material and 3D printer used.

The present invention will now be described with reference to Examples and Comparative Examples, which are not intended to limit the present invention.

## Example

Starting materials:

Component (A):

Multi-functional acrylate resin:

8411: is an aliphatic urethane diacrylate diluted 20% by weight with the reactive diluent isobornyl acrylate, i.e. EBECRYL®8411 from Allnex;

8413: is an aliphatic urethane diacrylate diluted 30% by weight with the reactive diluent isobornyl acrylate i.e. EBECRYL®8413 from Allnex;

9033: is urethane-based acrylate oligomer with 30% of Cyclic Trimethylopropane Formal Acrylate (CTFA), i.e. Laromer® UA9033 from BASF SE; and

PE-56F: is a high viscosity polyester-based acrylate, i.e. Laromer® PE-56F from BASF SE. BRC-843S: is a high viscosity hydrophobic urethane acrylate, i.e. Bomar® BRC-843S from Dymax.

Component (B):

Plasticizer:

DINA: diisononyladipate, i.e. Plastomoll®DNA from BASF SE;

DOA: dioctyl adipate, i.e. Plastomoll®DOA from BASF SE;

DINCH:1,2-cyclohexane dicarboxylic acid diisonnyl ester i.e. Hexamoll® DINCH® from BASF; 652: derived from adipic acid and polyhydric alcohols, i.e. Palamoll®652 from BASF SE.

Component (C):

Reactive diluent:

1122: monofunctional urethane acrylate, i.e. Genomer® 1122 from BASF SE;

ACMO: Acryloylmorpholine, which is available from RAHN; and

4-HBA: 4-Hydroxybutyl Acrylate, which is available from BASF SE.

8887: Trimethylolpropane formal acrylate, i.e. Laromer LR 8887 from BASF SE.

Component (D):

Photoinitiator:

TPO: 2,4,6-trimethylbenzoyldiphenylphosphine oxide, i.e. Omnirad TPO from IGM.

Test Methods:

(1) Glass transition temperature (Tg)

Glass transition temperature is determinedby means of Dynamic thermomechanical analysis (DMA) according to ASTM D5026-15 with a TA Instruments (i.e. RSA G2), wherein the parameters used include: Heating range: from -70 to 150°C, Heating rate: 2°C/min, Frequency: 1H, Strain: 1%.

(2) Hardness

Hardness is determined in accordance with ASTM D2240-15 with ASKER DUROMETER (TYPE A).

(3) Energy Return (Cyclic Tensile Test)

Energy return is determined according to ISO 527-5:2009 with Stable Micro Systems Texture Analyser (TA-HD plus), wherein the parameters used include: Pre-test Speed: 60.0 mm/min; Test Speed (load): 100.2 mm/min; Post-test Speed (unload): 100.2 mm/min; Strain: 50%; Cycles: 6.
The energy return is calculated by the area under loading curve and unloading curve:

**Energy Return** = (*Area Under Unloading Curve*)/(*Area Under Loading Curve*) * 100%

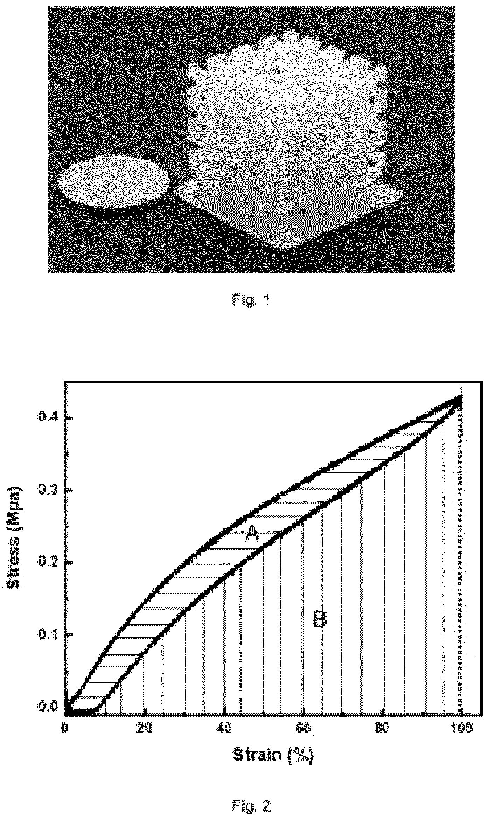

In Figure 2, Energy Return = B/(A+B)*100%, wherein B represents Area Under Unloading Curve, and A+B representsArea Under Loading Curve .

(4) Tensile test (including Tensile strength, Young's modulus and Elongation at break)

Tensile strength, Young's modulus and Elongation at break are determined according to ISO 527-5:2009 with Zwick, Z050 Tensile equipment, wherein the parameters used include: Start position: 50 mm; Pre-load: 0.02 MPa; Test speed: 50 mm/min.

1. Preparation of the composition

The specific formulations used in the following examples are shown in Table 1.

Table 1: The specific formulations used in the examples

| Components (g) | | Examples No. | | | | | | | | | | | | | | | | | |
|---|---|---|---|---|---|---|---|---|---|---|---|---|---|---|---|---|---|---|---|
| | | 1* | 1a | 1b | 2* | 2a | 2b | 3* | 3a | 3b | 3c | 4* | 4a | 4b | 4c | 4d | 4e | 5* | 5a | 5b |
| (A) | 8413 | | | | | | | 40 | 40 | 40 | 40 | | | | | | | | | |
| | 8411 | 40 | 40 | 40 | | | | | | | | | | | | | | | | |
| | PE56F | | | | 40 | 40 | 40 | | | | | | | | | | | | | |
| | 9033 | | | | | | | | | | | 100 | 95 | 80 | 60 | 50 | 40 | | | |
| | BRC-843S | | | | | | | | | | | | | | | | | 50 | 40 | 30 |
| (B) | 652 | | | | | | | | | | | | | | | | | 0 | 20 | 40 |
| | DINA | | | | 0 | 10 | 20 | 0 | 10 | 20 | 40 | | | | | | | | | |
| | DOA | 0 | 10 | 20 | | | | | | | | | | | | | | | | |
| | DINCH | | | | | | | | | | | 0 | 5 | 20 | 40 | 50 | 60 | | | |
| (C) | 8887 | | | | | | | | | | | | | | | | | 50 | 40 | 30 |
| | ACMO | 40 | 40 | 40 | | | | 20 | 20 | 20 | 20 | | | | | | | | | |
| | 4-HBA | | | | | | | 20 | 20 | 20 | 20 | | | | | | | | | |
| | 1122 | | | | 40 | 40 | 40 | | | | | | | | | | | | | |
| (D) | TPO | 2 | 2 | 2 | 2 | 2 | 2 | 2 | 2 | 2 | 2 | 2 | 2 | 2 | 2 | 2 | 2 | 2 | 2 | 2 |
| Total weight (g) | | 82 | 92 | 102 | 82 | 92 | 102 | 82 | 92 | 102 | 122 | 102 | 102 | 102 | 102 | 102 | 102 | 102 | 102 | 102 |

Note: * denote comparative example.

The abbreviations or symbols have the meaning as mentioned above.

EP 4 455 792 A2

Comparative Example 1*

40g 8411, 40g ACMO and 2g TPO were added into a plastic vial and mixed by speed-mixer at 2000 RPM for 10 minutes at 25°C. This gives a photo-curable liquid resin composition 1*.

Inventive Example 1a

40g 8411, 40g ACMO, 10g DOA and 2g TPO were added into a plastic vial and mixed by speed-mixer at 2000 RPM for 10 minutes at 25°C.This gives a photo-curable liquid resin composition 1a.

Inventive Example 1b

40g 8411, 40g ACMO, 20g DOA and 2g TPO were added into a plastic vial and mixed by speed-mixer at 2000 RPM for 10 minutes at 25°C.This gives a photo-curable liquid resin composition 1b.

Comparative Example 2*

40g PE56F, 40g 1122 and 2g TPO were added into a plastic vial and mixed by speed-mixer at 2000 RPM for 10 minutes at 25∘C. This gives a photo-curable liquid resin composition 2*.

Example 2a

40g PE56F, 40g 1122, 10g DINA and 2g TPO were added into a plastic vial and mixed by speed-mixer at 2000 RPM for 10 minutes at 25°C.This gives a photo-curable liquid resin composition 2a.

Example 2b

40g PE56F, 40g 1122, 20g DINA and 2g TPO were added into a plastic vial and mixed by speed-mixer at 2000 RPM for 10 minutes at 25°C. This gives a photo-curable liquid resin composition 2b.

Comparative Example 3*

40g 8413, 20g 4-HBA, 20g ACMO and 2 g TPO were added into a plastic vial and mixed by speed-mixer at 2000 RPM for 10 minutes at 25∘C. This gives a photo-curable liquid resin composition 3*.

Example 3a

40g 8413, 20g 4-HBA, 20g ACMO, 10g DINA and 2 g TPO were added into a plastic vial and mixed by speed-mixer at 2000 RPM for 10 minutes at 25°C. This gives a photo-curable liquid resin composition3a.

Example 3b

40g 8413, 20g 4-HBA, 20g ACMO, 20g DINA and 2g TPO were added into a plastic vial and mixed by speed-mixer at 2000 RPM for 10 minutes at 25°C. This gives a photo-curable liquid resin composition 3b.

Example 3c

40g 8413, 20g 4-HBA, 20g ACMO, 40g DINA and 2g TPO were added into a plastic vial and mixed by speed-mixer at 2000 RPM for 10 minutes at 25∘C. This gives a photo-curable liquid resin composition 3c.

Comparative Example 4*

200g 9033 and 4g TPO were added into a plastic vial and mixed by speed-mixer at 2000 RPM for 10 minutes at 25∘C. This gives a photo-curable liquid resin composition 4*.

Example 4a

190g 9033, 10g DINCH and 4g TPO were added into a plastic vial and mixed by speed-mixer at 2000 RPM for 10 minutes at 25°C. This gives a photo-curable liquid resin composition 4a.

Example 4b

160g 9033, 40g DINCH and 4g TPO were added into a plastic vial and mixed by speed-mixer at 2000 RPM for 10 minutes at 25∘C. This gives a photo-curable liquid resin composition 4b.

Example 4c

120g 9033, 80g DINCH and 4g TPO were added into a plastic vial and mixed by speed-mixer at 2000 RPM for 10 minutes at 25∘C. This gives a photo-curable liquid resin composition 4c.

Example 4d

100g 9033, 100g DINCH and 4g TPO were added into a plastic vial and mixed by speed-mixer at 2000 RPM for 10 minutes at 25∘C. This gives a photo-curable liquid resin composition 4d.

Example 4e

80g 9033, 120g DINCH and 4g TPO were added into a plastic vial and mixed by speed-mixer at 2000 RPM for 10 minutes at 25∘C. This gives a photo-curable liquid resin composition 4e.

Comparative Example 5*

100g BRC-843S, 100g 8887 and 4g TPO were added into a plastic vial and mixed by speed-mixer at 2000 RPM for 10 minutes at 25∘C. This gives a photo-curable liquid resin composition 5*.

Example 5a

80g BRC-843S, 80g 8887, 40g 652 and 4g TPO were added into a plastic vial and mixed by speed-mixer at 2000 RPM for 10 minutes at 25∘C. This gives a photo-curable liquid resin composition 5a.

Example 5b

60g BRC-843S, 60g 8887, 80g 652 and 4g TPO were added into a plastic vial and mixed by speed-mixer at 2000 RPM for 10 minutes at 25°C. This gives a photo-curable liquid resin composition 5a.

2. Test of the casting samples

2.1 Preparation of the cured sample

1.8g of every composition obtained in the above examples were each casted by a UV LED curing system-YW150100 (Manufactured by UVPRO Co., Ltd.) at 25°C for 0.1min, wherein LED light source is 405 nm; Track speed is 3 m/min; the energy passed through once is 1298 mJ/cm$^2$; the sample needs to go four times. Then, the specimens obtained as a whole were each post cured by a NextDent™ LC-3DPrint Box for 60 min, wherein 12 lamps with a power of 18W (6 color numbers 71 & 6 color numbers 78) were used in this procedure.

2.2 Preparation of the test bar

The cured samples obtained from above were each cut to be a Strip-shaped test bar, having a dimension of 40 mm × 4 mm × 2 mm.

2.3 Test results

The test bars were tested as described above, respectively. The test results are shown in the following Table 2.

Table 2: The test results of the cured compositions

| Test type | Compositions No. | | | | | | | | | | | | | | | | | | |
|---|---|---|---|---|---|---|---|---|---|---|---|---|---|---|---|---|---|---|---|
| | 1* | 1a | 1b | 2* | 2a | 2b | 3* | 3a | 3b | 3c | 4* | 4a | 4b | 4c | 4d | 4e | 5* | 5a | 5b |
| Tensile Strength (Mpa) | 33.9 | 25.3 | 14.7 | 7.8 | 4.2 | 3.6 | 28.1 | 12.8 | 9.6 | 6.2 | 13.65 | 8.99 | 4.02 | 1.44 | 0.82 | 0.45 | 11.0 | 3.1 | 0.8 |
| Young's Modulus (Mpa) | 1120 | 430 | 157 | 19.3 | 12 | 6.9 | 300 | 32.7 | 5.6 | 0.65 | 25.2 | 16.4 | 6.71 | 1.95 | 1.11 | 0.65 | 5.86 | 1.71 | 1.7 |
| Elongation at break (%) | 145 | 219 | 217 | 28.1 | 25.3 | 29.4 | 262 | 301.8 | 303.7 | 324.5 | 81.0 | 76.0 | 64.8 | 53.3 | 55.7 | 53.5 | 130 | 118 | 103 |
| Tg (°C) | 99 | 83.9 | 86 | - | - | - | - | - | - | - | 25.3 | 22.6 | 16.6 | 9.5 | 8.6 | - | 18.5 | 2.9 | 9.0 |
| Hardness | 70D | 55 D | 47 D | 91 A | 85 A | 84 A | 96 A | 72A | 63A | 35A | 90A | 84 A | 67 A | 47 A | 36 A | 26 A | 80 A | 52 A | 32 A |
| Energy Return (%) | - | - | - | - | - | - | 11.7 | 22.9 | 40.5 | 53.5 | 39.4 | 46.3 | 60.9 | 68.9 | 67.7 | 67.2 | 33.7 | 72.6 | 82.3 |

From Table 2, it can be seen that by introducing the plasticizer into the compositions, most of the resulting samples show significant improvement in terms of hardness, Tg, Modulus, and energy return with increase of the content of plasticizer. Especially from groups 4 and 5, it can be seen that the addition of the large amount of the plasticizers could improve and maintain the energy return of material at a high level. The test results exhibit substantial improvement in hardness, Tg and Modulus. The facts also show that the introduction of the plasticizer contributes to an improved flexible and elastic material properties in cured state.

3.Test for the comparison of casting and printing samples

3.1 Preparation of the cured sample

Compositions 5, 5a and 5b obtained in the above examples were each cured by the means of 3D-printing. Specifically, 150g of compositions 5, 5a and 5b were each printed layer by layer using MiiCraft 1503D printer (Manufactured by MiiCraft) at 25°C, wherein the parameters in 3D printer include: Print Thickness: 50 $\mu$m; Curing Time: 3.00 s; Speed: Slow; Gap. Adj: 0.1 mm; Base Layers: 2; Base Curing Time: 5 s; Buffer Layers: 2; Power 110% (about 6.6 mW/cm$^2$). Then, the specimens obtained as a whole were each post cured by a NextDent™ LC-3DPrint Box for 60 min, wherein 12 lamps with a power of 18W (6 color numbers 71 & 6 color numbers 78) were used in this procedure.

3.2 Preparation of the test bar

The cured samples 5, 5a and 5b obtained as above were each cut to be a Strip-shaped test bar, having a dimension of 40 mm ×4 mm × 2 mm.

3.3 Test results

The test bars were tested as described above, respectively. The test results are shown in the following Table 3. For comparison, the data as to casted compositions 5*, 5a and 5b was also listed in Table 3.

Table 3

| Test type | Compositions | | | | | |
|---|---|---|---|---|---|---|
| | 3D-Printed composition 5* | Casted composition 5* | 3D-Printed composition 5a | Casted composition 5a | 3D-Printed composition 5b | Casted composition 5b |
| Hardness (Shore A) | 75 | 80 | 51 | 52 | 35 | 32 |
| Young's Modulus (MPa) | 5.29 | 5.86 | 2.32 | 1.71 | 0.93 | 0.70 |
| Tensile Strength (MPa) | 7.1 | 11.0 | 1.9 | 3.1 | 0.6 | 0.8 |
| Elongation at break (%) | 105 | 130 | 79 | 118 | 59 | 103 |
| Energy Return (%) | 53.3 | 33.7 | 82.9 | 72.6 | 88.3 | 82.3 |
| Tg (°C) | 17.5 | 18.5 | 3.7 | 2.9 | 10.5 | 9.0 |

From Table 3, it can be seen that hardness, stress, elongation and Tg of the printing samples are a little bit smaller than that of the casting samples, and the energy return of the former is a little bit larger than that of the latter. However, considering the difference in the preparation process, it can be thought that they have similar mechanical properties. Thus, the samples obtained by 3D-printing should have similar properties to those obtained by casting. The above Test 2 can simulate the testing results of mechanical properties of corresponding printing samples, and the conclusions obtained in Test 2 could also apply to the 3D-printed compositions 1* to 5b. Moreover, it is surprisingly found that even used in large amount, the plasticizer still functions well in the 3D-printed samples, further significantly improving the elasticity of the sample without migration.

**Claims**

1. A photo-curable liquid resin composition for 3D printing, comprising

    (A) 1 to 90% by weight of an oligomer containing an ethylenically unsaturated radiation curable functional group;
    (B) 1 to 90% by weight of a plasticizer;
    (C) 0 to 90% by weight of reactive diluents;
    (D) 0.1 to 10% by weight of a photoinitiator; and
    (E) 0 to 5% by weight of auxiliaries,

    wherein the total weight of components (A) to (E) is 100% by weight.

2. The composition according to claim 1, wherein the oligomer containing an ethylenically unsaturated radiation curable functional group (A) includes the oligomer containing an ethylenically unsaturated radiation curable mono- and/or poly-functional group.

3. The composition according to claim 1 or 2, wherein oligomer (A) is present in an amount of from 5 to 80% by weight.

4. The composition according to any one of claims 1 to 3, wherein oligomer (A) comprises ethylenically unsaturated oligomers of the following general classes: urethane, polyether, polyester, polycarbonate, polyestercarbonate, acrylic, silicone or any combination thereof, preferably, oligomer (A) comprises an urethane-based oligomer, an acrylate-based oligomer, a polyester-based oligomer, a polyether-based oligomer, urethane acrylate-based oligomer, polyether urethane-based oligomer, polyester urethane-based oligomer or a silicone-based oligomer, as well as any combination or subset thereof.

5. The composition according to any one of claims 1 to 4, wherein plasticizer (B) is present in an amount of from 5 to 85% by weight, more preferably from 5 to 80% by weight, most preferably from 5 to 70% by weight, particularly from 5 to 60% by weight, in each case based on the total weight of components (A) to (E).

6. The composition according to any one of claims 1 to 5, wherein plasticizer (B) is selected from the group consisting of $C_3$-$C_{15}$, preferably $C_3$-$C_{10}$ polycarboxylic acids and their esters with linear or branched $C_2$-$C_{30}$ aliphatic alcohols, benzoates, epoxidized vegetable oils, sulfonamides, organophosphates, polymeric plasticizer, polybutene and polyisobutylene; preferably the plasticizer (B) is selected from the group consisting of $C_3$-$C_{15}$, preferably $C_3$-$C_{10}$ aromatic dicarboxylic or tricarboxylic acids and their esters with linear or branched $C_2$-$C_{30}$ aliphatic alcohols, $C_3$-$C_{15}$, preferably $C_3$-$C_{10}$ aliphatic dicarboxylic or tricarboxylic acids and their esters with linear or branched $C_2$-$C_{30}$ aliphatic alcohols, benzoates, epoxidized vegetable oils, sulfonamides, organophosphates, polymeric plasticizer, polybutene and polyisobutylene; still preferably the polymeric plasticizer is polyester plasticizer which is obtained by esterification of polyhydric alcohol.

7. The composition according to any one of claims 1 to 6, where in the reactive diluent (C) is present in an amount of from 0 to 80% by weight based on the total weight of components (A) to (E).

8. The composition according to any one of claims 1 to 7, wherein the reactive diluent (C) is monofunctional or multifunctional monomer; preferably the reactive diluent (C) is one or more monofunctional or multifunctional monomer selected from the group consisting of acrylic acid; acrylate monomer selected from the group consisting of urethane acrylate, methyl (meth)acrylate, ethyl (meth)acrylate, butyl (methyl)acrylate, 2-(2-thoxyethoxy)ethyl acrylate, tetrahydrofurfuryl (meth)acrylate, lauryl acrylate, isooctyl acrylate, isodecyl acrylate, 2-phenoxyethyl acrylate, 2-ethylhexyl (meth)acrylate, isobornyl (meth)acrylate, dicyclopentenyloxyethyl (meth)acrylate, dicyclopentadienyl (meth)acrylate, 2-hydroxyethyl (meth)acrylate, 2-hydroxypropyl (meth)acrylate, 2-hydroxybutyl (meth)acrylate, 4-hydroxybutyl (meth)acrylate, caprolactone acrylate, morpholine (meth)acrylate, hexanediol di(meth)acrylate, ethyleneglycol dimethacrylate, trimethylolpropane triacrylate, pentaerythritol tetraacrylate, n-hexyl (meth)acrylate, stearyl acrylate, allyl acrylate, ethoxylatednonyl phenol acrylate, acrylated monomers and combinations thereof; and also vinyl alkyl oxazolidinone such as vinyl methyl oxazolidinone and acryloyl morpholine; more preferably the reactive diluent (C) is acrylate monomer such as urethane acrylate, isodecyl acrylate, 4-hydroxybutyl (meth)acrylate, trimethylolpropane acrylate, vinyl alkyl oxazolidinone such as vinyl methyl oxazolidinone, and acryloylmorpholine.

9. The composition according to any one of claims 1 to 8, wherein photoinitiator (D) is present in an amount of from 0.1 to 5% by weight, more preferably from 0.1 to 4% by weight, in each case based on the total weight of components (A) to (E).

10. The composition according to any one of claims 1 to 9, wherein photoinitiator (D) is selected from the group consisting of 1-hydroxycyclohexyl phenylketone, 2-methyl-1-[4-(methyl-thio)phenyl]-2-morpholinopropan-1-one, 2-benzyl-2-N,N-dimethylamino-1-(4-morpholinophenyl)-1-butanone, combination of 1-hydroxycyclohexyl phenyl ketone and benzophenone, 2,2-dimethoxy-2-phenyl acetophenone, combination of bis(2,6-dimethoxybenzoy 1-2,4,4-trimethylpentyl)phosphine oxide and 2-hydroxy-2-methyl-1-phenyl-propan-1-one, bis(2,4,6-trimethyl benzoyl) phenyl phosphine oxide, 2-hydroxy-2-methyl-1-phenyl-1-propane, combination of 2,4,6-trimethylbenzoyldiphenyl-phosphine oxide and 2-hydroxy-2-methyl-1-phenyl-propan-1-one; 2,4,6-trimethylbenzoyldiphenylphosphinate and 2,4,6-trimethylbenzoyldiphenyl-phosphine oxide.

11. The composition according to any one of claims 1 to 10, wherein auxiliaries (E) is present in an amount of from 0 to 4% by weight, in each case based on the total weight of components (A) to (E).

12. A process for preparing photo-curable liquid resin composition according to any one of claims 1 to 11, comprising mixing the components (A) to (E) in the amounts as defined in claims any one of claims 1 to 11.

13. The process according to claim 12, wherein the mixing is carried out at room temperature with stirring.

Fig. 1

Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 106186810 A
- CN 105419306 A
- WO 2014172716 A1
- WO 2016153711 A1
- WO 2010125009 A

**Non-patent literature cited in the description**

- Plastics Additive Handbook. Hanser Publishers, 2001, 98-107, 116, , 121
- Plastics Additive Handbook. Hanser Publishers, 2001, 116-122
- Plastics Additive Handbook. Hanser Publishers, 2001